# EUROPEAN PATENT APPLICATION

(11) **EP 4 839 074 A1**
(43) Date of publication of application: **11.11.2026**
(21) Application number: 25223666.6
(22) Date of filing: 16.12.2025
(51) Int. Cl.: H10W 20/40, H10W 40/20, H10W 70/60, H10W 72/60, H10W 76/43, H10W 90/10, H10W 90/15, H10W 90/20, H10W 90/00

(54) **THREE-DIMENSIONAL VOLTAGE REGULATORS FOR BACKSIDE POWER DELIVERY**

(30) Priority: 09.05.2025 US 202519203385
(71) Applicant: Intel Corporation, Santa Clara, CA 95054 (US)
(72) Inventor: SINGH, Binay Kumar, Portland, 97229 (US); DUONG, Benjamin T., Phoenix, 85044 (US); HENDRICKS, Clive R., Gilbert, 85295 (US); PIETAMBARAM, Srinivas Venkata Ramanuja, Chandler, 95249 (US); BUSSELLE, Lincoln P., Gilbert, 85297 (US); SAH, Sanjay Kumar, Prtland, 97229 (US)
(74) Representative: 2SPL Patentanwälte PartG mbB

(57) **Abstract**

Technologies for three-dimensional voltage regulators for backside power delivery are disclosed. In an illustrative embodiment, components of a voltage regulator are grouped together in a three-dimensional form factor. Such an approach reduces the footprint of the voltage regulator and raises the profile. In some embodiments, interconnects carry power from the top of the three-dimensional voltage regulator to the back side of an integrated circuit die. The three-dimensional voltage regulator takes up less space on a circuit board, can be easier to cool, can be more efficient, and can be flexible in regard to physical arrangement in an integrated circuit component.

## Description

### BACKGROUND

Semiconductor dies such as processors require a large amount of power at a relatively low voltage. Providing high power at a low voltage across a long distance, such as from a power supply to the die, leads to high resistive losses and can result in a noisy voltage supply to the processor.

Voltage regulators can efficiently step down voltages from an intermediate voltage to a voltage suitable for the processor. Voltage regulators can be near the processor, reducing resistive losses and noise. However, voltage regulators can take up a large footprint and dissipate a lot of power, which can lead to reduced efficiency. Cooling can increase the efficiency, but cooling the voltage regulators can be difficult, adding cost and complexity. Additionally, voltage regulators are connected to the processor through a printed circuit board, a socket, a package, and then a die, which can result in some losses and reduced area available to route data traces.

### BRIEF DESCRIPTION OF THE DRAWINGS

FIG. 1 is an isometric view of an integrated circuit component.
FIG. 2 is a cross-sectional view of one embodiment of the integrated circuit component of FIG. 1 including a three-dimensional voltage regulator.
FIG. 3 is a circuit diagram of one embodiment of the three-dimensional voltage regulator of FIG. 2.
FIG. 4 is a cross-sectional view of one embodiment of the three-dimensional voltage regulator of FIG. 2.
FIG. 5 is a cross-sectional view of one embodiment of the integrated circuit component of FIG. 1 including a three-dimensional voltage regulator.
FIG. 6 is a cross-sectional view of one embodiment of the integrated circuit component of FIG. 1 including a three-dimensional voltage regulator.
FIG. 7 is a cross-sectional view of one embodiment of an integrated circuit component including a three-dimensional voltage regulator.
FIG. 8 is a cross-sectional view of one embodiment of the integrated circuit component of FIG. 1 including a three-dimensional voltage regulator.
FIG. 9 is a cross-sectional view of one embodiment of the integrated circuit component of FIG. 1 including a three-dimensional voltage regulator.
FIG. 10 is a cross-sectional view of one embodiment of the integrated circuit component of FIG. 1 including a three-dimensional voltage regulator.
FIG. 11 is a cross-sectional view of one embodiment of an integrated circuit component including a three-dimensional voltage regulator.
FIG. 12 is a cross-sectional view of one embodiment of the integrated circuit component of FIG. 1 including a three-dimensional voltage regulator.
FIG. 13 is a cross-sectional view of one embodiment of the integrated circuit component of FIG. 1 including a three-dimensional voltage regulator.
FIG. 14 is a top view of a wafer and dies that may be included in a microelectronic assembly, in accordance with any of the embodiments disclosed herein.
FIG. 15 is a cross-sectional side view of an integrated circuit device that may be included in a microelectronic assembly, in accordance with any of the embodiments disclosed herein.
FIGS. 16A-16D are perspective views of example planar, gate-all-around, and stacked gate-all-around transistors.
FIG. 17 is a cross-sectional side view of an integrated circuit device assembly that may include a microelectronic assembly, in accordance with any of the embodiments disclosed herein.
FIG. 18 is a block diagram of an example electrical device that may include a microelectronic assembly, in accordance with any of the embodiments disclosed herein.

### DETAILED DESCRIPTION

In various embodiments disclosed herein, an integrated circuit component includes a three-dimensional voltage regulator. The three-dimensional voltage regulator may include one or more capacitors, inductors, transistors, etc., to supply a voltage to a die of the integrated circuit component. Power from the three-dimensional voltage regulator may be carried by an interconnect to the back side of the die. For example, in one embodiment, the interconnect may be embedded in an integrated heat sink of the integrated circuit component.

As used herein, the phrase "communicatively coupled" refers to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate and an integrated circuit component attached to a printed circuit board that send signals to or receives signals from other integrated circuit components or electronic devices attached to the printed circuit board.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact, and "coupled" may indicate elements co-operate or interact, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, the central axis of a magnetic plug that is substantially coaxially aligned with a through hole may be misaligned from a central axis of the through hole by several degrees. In another example, a substrate assembly feature, such as a through width, that is described as having substantially a listed dimension can vary within a few percent of the listed dimension. Further, when a particular feature, structure, or characteristic is described in connection with an embodiment, it is submitted that it is within the knowledge of one skilled in the art to effect such feature, structure, or characteristic in connection with other embodiments whether or not explicitly described. Additionally, it should be appreciated that items included in a list in the form of "at least one A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The disclosed embodiments may be implemented, in some cases, in hardware, firmware, software, or any combination thereof. The disclosed embodiments may also be implemented as instructions carried by or stored on a transitory or non-transitory machine-readable (e.g., computer-readable) storage medium, which may be read and executed by one or more processors. A machine-readable storage medium may be embodied as any storage device, mechanism, or other physical structure for storing or transmitting information in a form readable by a machine (e.g., a volatile or non-volatile memory, a media disc, or other media device).

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

Reference is now made to the drawings, which are not necessarily drawn to scale, wherein similar or same numbers may be used to designate the same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

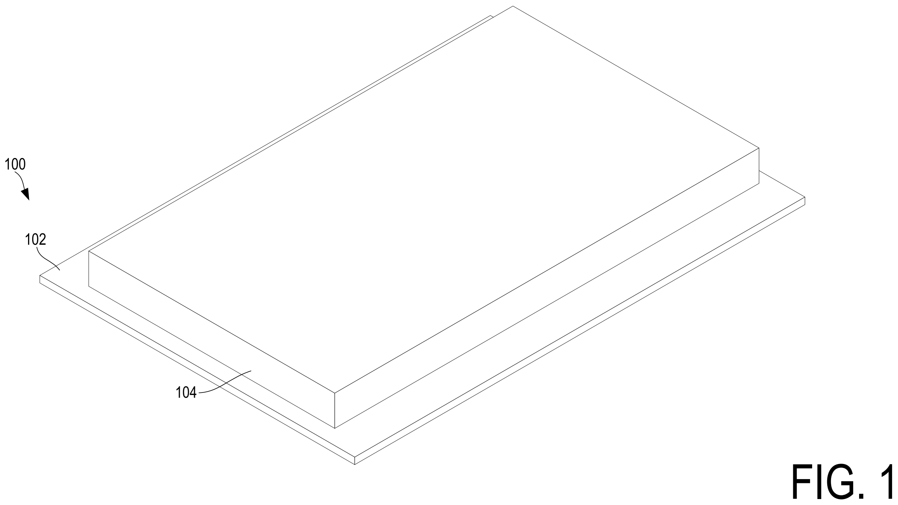

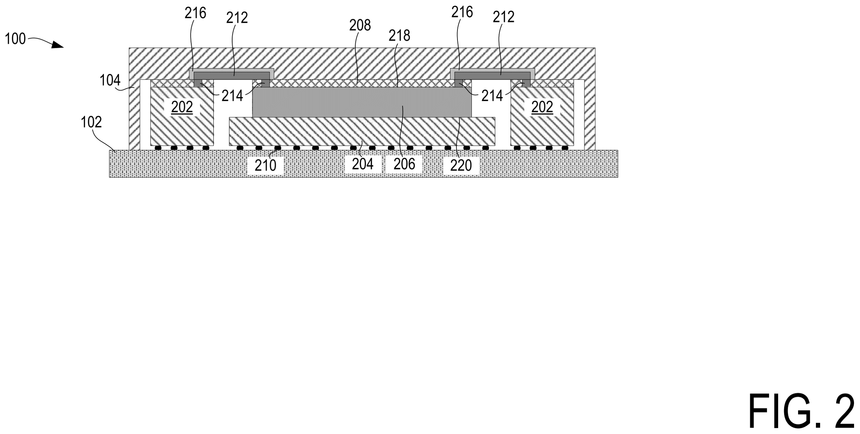

Referring now to FIGS. 1-2, in one embodiment, an integrated circuit component 100 includes a circuit board 102, one or more three-dimensional voltage regulators 202, a substrate 204, one or more dies 206, and an integrated heat spreader (IHS) 104. FIG. 1 shows a perspective view of the integrated circuit component 100, and FIG. 2 shows a cross-sectional view of one embodiment of the integrated circuit component 100. The integrated circuit component 100 may include other components, such as additional dies, additional components such as capacitors, inductors, additional voltage regulators, etc.

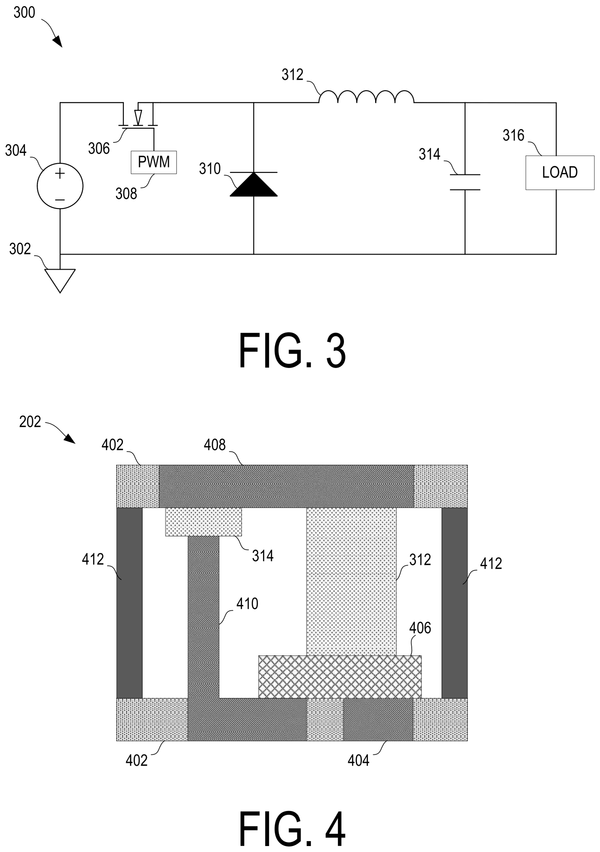

In an illustrative embodiment, the three-dimensional voltage regulator 202 includes a voltage regulator circuit, such as a buck converter. A circuit diagram of one embodiment of a three-dimensional voltage regulator circuit 300 that may form part of the three-dimensional voltage regulator 202 is shown in FIG. 3, and a cross-sectional view of one embodiment of the three-dimensional voltage regulator 202 is shown in FIG. 4. In some embodiments, the three-dimensional voltage regulators 202 may be referred to as a power tower, a three-dimensional power circuit, etc.

As shown in FIG. 3, the three-dimensional voltage regulator circuit 300 may include a signal ground 302, a voltage source 304, a transistor 306, a pulse-width modulator 308, a diode 310, an inductor 312, a capacitor 314, and a load 316. In use, the pulse-width modulator 308 controls the transistor 306 to supply charge to the capacitor 314, which keeps the voltage across the capacitor within a specified voltage range for the load 316. The load 316 may be, e.g., the die 206.

Referring now to FIG. 4, in one embodiment, the three-dimensional voltage regulator 202 may implement a similar circuit as the three-dimensional voltage regulator circuit 300. The three-dimensional voltage regulator 202 includes substrates 402, a conductor 404, driving circuitry 406, the inductor 312, conductor 408, the capacitor 314, conductor 410, and shielding 412. The conductor 404 may be connected to an input voltage source, conductor 408 may provide the output voltage, and conductor 410 may be connected to signal ground. The driving circuitry 406 may include the transistor 306, pulse-width modulator 308, control circuitry, voltage feedback circuitry, and/or other circuitry to drive and control the three-dimensional voltage regulator 202.

The three-dimensional voltage regulator 202 may include additional or different components from that shown in FIGS. 3 and 4. For example, the three-dimensional voltage regulator 202 may include a boost converter, a buck-boost converter, or any other suitable type of voltage regulator. The three-dimensional voltage regulator 202 may include voltage regulators for more than one voltage and/or for more than one phase for the same voltage. The three-dimensional voltage regulator 202 may provide any suitable voltage level as an output, such as 1.8V, 1.2V, 1.0V, 0.8V, and/or any voltage from, e.g., 0-5V.

The three-dimensional voltage regulator 202 may have any suitable dimensions. In an illustrative embodiment, the three-dimensional voltage regulator 202 has a length, width, and/or height of, e.g., 1-15 millimeters. In general, the height of the three-dimensional voltage regulator 202 may be, e.g., 0.25-4 times the length and/or width of the three-dimensional voltage regulator 202. It should be appreciated that the three-dimensional voltage regulator 202 has a smaller footprint than a corresponding conventional voltage regulator. For example, in one embodiment, a three-dimensional voltage regulator 202 may have a footprint of about 90 square millimeters, while a corresponding conventional voltage regulator would require a footprint of about 225 square millimeters.

Referring back to FIG. 2, in an illustrative embodiment, the output of the three-dimensional voltage regulator 202 (e.g., the conductor 408 shown in FIG. 4) may be located at the top of the three-dimensional voltage regulator 202, near the IHS 104. Power can be delivered from the three-dimensional voltage regulator 202 through an interconnect 212 to the back side 218 of the die. In an illustrative embodiment, the interconnect 212 is embedded in the IHS 104. A dielectric layer 216 may surround the interconnect 212, electrically isolating it from the rest of the IHS 104. The three-dimensional voltage regulator 202 and/or the die 206 may be connected to the interconnect 212 through solder balls 214, copper bumps, gold fingers, pogo pins, springs, compression contacts, or other connectors. Interconnect may be used to describe the interconnect 212 in the IHS 104 as well as the solder balls 214, copper bumps, or other connectors. The interconnect 212 may be made of any suitable conductor, such as copper, aluminum, solder, etc.

The three-dimensional voltage regulator 202 offers several advantages. The connection from the top of the three-dimensional voltage regulator 202 to the back side 218 of the die 206 offers a shorter path compared to going through the circuit board 102 and substrate 204. In some embodiments, the die 206 may implement back side power delivery, in which case providing power directly to the back side 218 can be advantageous. Use of a three-dimensional voltage regulator 202 allows for flexibility, as the three-dimensional voltage regulator 202 can be mounted on or interface with circuit boards, interposers, substrates, dies, etc. In some cases, the three-dimensional voltage regulator 202 may require significant cooling in order to provide high-efficiency voltage regulation. The high aspect ratio of the three-dimensional voltage regulator 202 allows it to be thermally coupled to the IHS 104, as shown in FIG. 4, providing the necessary cooling to operate efficiently. The three-dimensional voltage regulator 202 has a smaller footprint compared to a voltage regulator with several discrete components on the surface of the circuit board 102, increasing the area of the circuit board 102 that is available for other components and/or reducing the required size of the circuit board 102. As the power can be provided from the top of the three-dimensional voltage regulator 202 directly to the back side of the die 206, there is also less area on the circuit board 102 required for power traces to the substrate 204, allowing for space for data traces and data connections to the substrate 204 and the front side 220 of the die 206. Reducing the number of connections (e.g., pins in a pin grid array or balls in a ball grid array) dedicated to power can reduce the overall pin count and/or increase the number of pins available for data input and output.

The illustrative circuit board 102 may be made from ceramic, glass, and/or organic-based materials with fiberglass and resin, such as FR-4. The circuit board 102 may have any suitable length or width, such as 10-500 millimeters. The circuit board 102 may have any suitable thickness, such as 0.2-5 millimeters. The circuit board 102 may support additional components besides the components shown in FIGS. 1-2, such as additional photonic or electronic integrated circuit components, a memory device such as a static random access memory (SRAM) device, additional circuit components, etc.

The substrate 204 may be made from ceramic, glass, semiconductor, and/or organic-based materials. The substrate 204 may have a core with one or more build-up layers. The substrate provides electrical connections between the circuit board 102 and the one or more dies 206.

In an illustrative embodiment, the one or more dies 206 are mounted on the substrate 204, and the substrate 204 is mounted on the circuit board 102. In an illustrative embodiment, the substrate 204 is connected to the circuit board 102 with solder balls 210. A thermal interface material (TIM) 208 is between the die 206 and the IHS 104. The TIM 208 may be any suitable material, such as a silver thermal compound. TIM 208 may also be present between the three-dimensional voltage regulator 202 and the IHS 104.

The one or more dies 206 may include any suitable electronic integrated circuit component, such as transistors, resistors, capacitors, inductors, etc. The one or more dies 206 may include any suitable analog and/or digital circuitry, such as a processor, a memory, an application-specific integrated circuit (ASIC), a field-programmable gate array (FPGA), etc. The dies 206 may have any suitable length or width, such as 1-300 millimeters. The dies 206 may have any suitable thickness, such as 0.05-5 millimeters. The IHS 104 may be made of any suitable material with a high thermal conductivity, such as copper, aluminum, other metals, metal alloys, coated metals, combinations of metals, etc.

It should be appreciated that the embodiment described above is merely one possible embodiment, and other embodiments are envisioned where the various components are arranged in a different manner and/or where different components are included. Various non-limiting examples are described in further detail below. It should be appreciated that the various features of the various examples may be used together or separately, as appropriate.

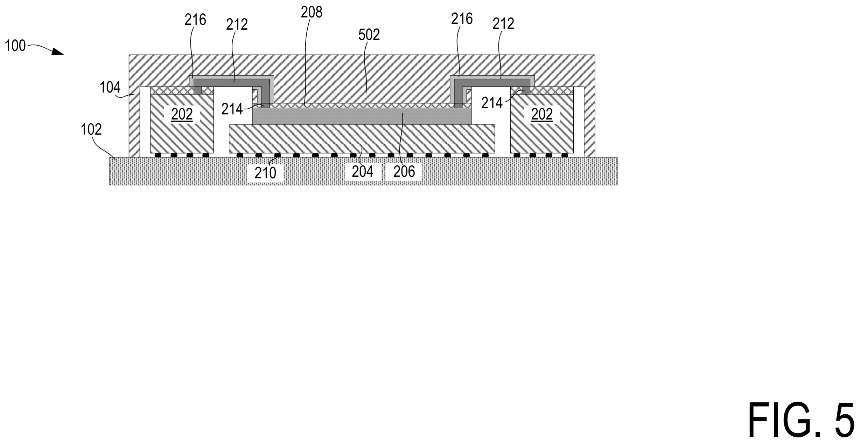

Referring now to FIG. 5, in one embodiment, the IHS 104 may include a pedestal 502 extending from the body of the IHS 104 towards the die 206. Such a pedestal 502 may be used when, e.g., the height of the three-dimensional voltage regulators 202 is more than that of the substrate 204 and die 206. The pedestal 502 may allow the IHS 104 to be in strong thermal contact with the die 206 and the three-dimensional voltage regulators 202. In some embodiments, the interconnects 212 may extend through the pedestal 502, as shown in the figure.

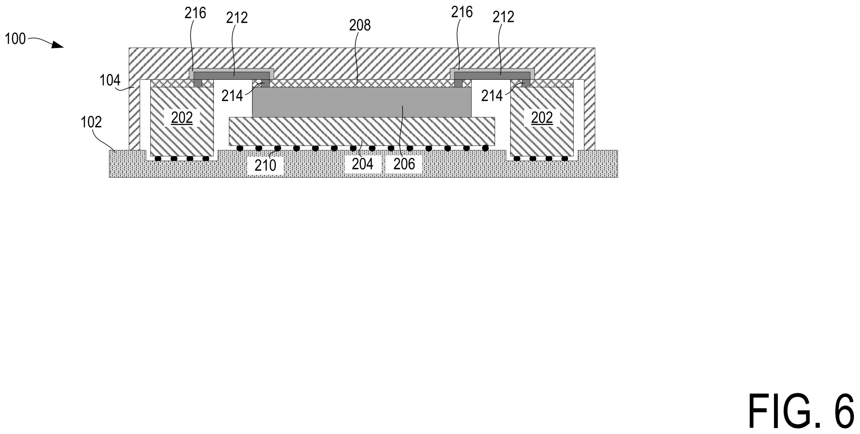

Referring now to FIG. 6, additionally or alternatively, in one embodiment, the three-dimensional voltage regulators 202 may be recessed into a cavity defined in the circuit board 102, as shown in the figure. The three-dimensional voltage regulators 202 recessed into the cavity defined in the circuit board 102 can allow the top of the three-dimensional voltage regulators 202 to be at about the same height as the die 206.

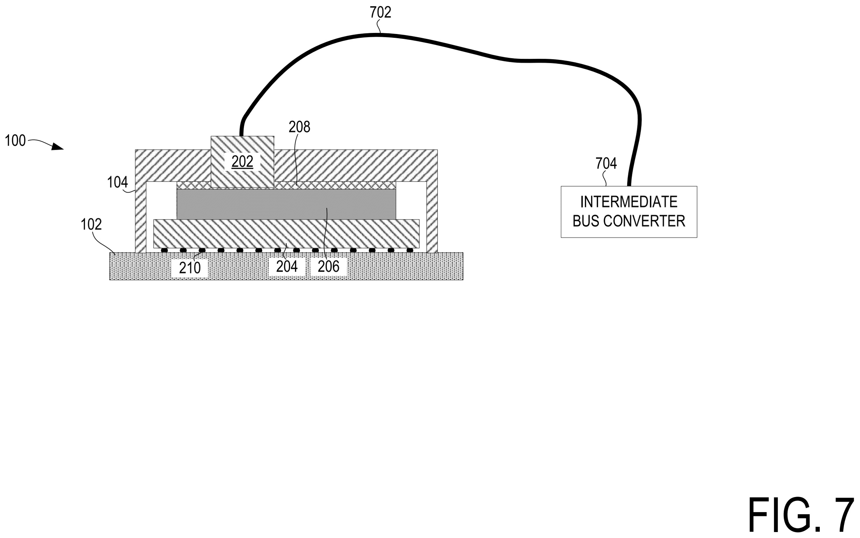

Referring now to FIG. 7, additionally or alternatively, in one embodiment, the three-dimensional voltage regulators 202 is placed directly on top of the die 206. The three-dimensional voltage regulators 202 may extend through a gap defined in the IHS. In some embodiments, the ground and/or a voltage may be supplied to the three-dimensional voltage regulators 202 from an intermediate bus converter 704 through a cable 702. The intermediate bus converter 704 may be disposed in a power supply on the circuit board 102, on a motherboard, and/or in another suitable location.

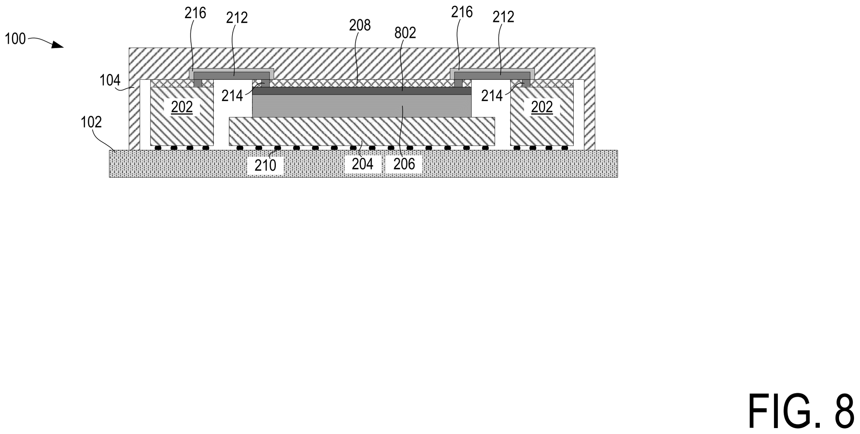

Referring now to FIG. 8, additionally or alternatively, in one embodiment, an interposer 802 may be positioned between the die 206 and the IHS 104. The three-dimensional voltage regulator 202 may provide power to the die 206 through the interposer 802. The interposer 802 may distribute the voltage(s) received from the interconnect across the back side 218 of the die 206. The interposer 802 may be made of any suitable material, such as silicon, glass, ceramic, an organic material, an inorganic material, etc.

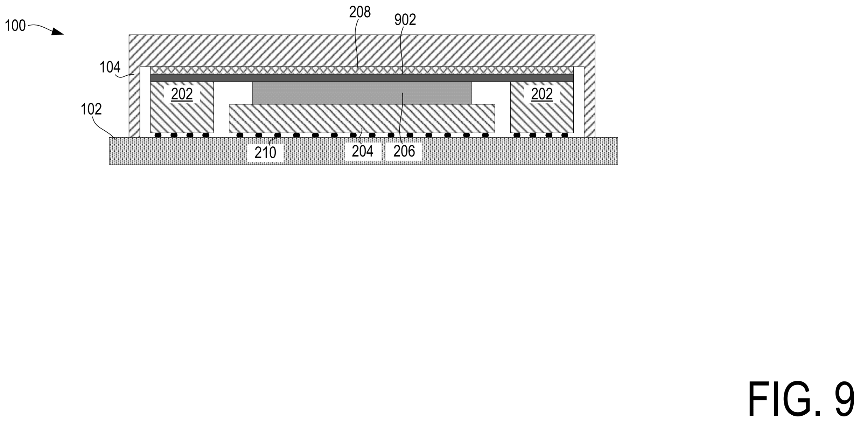

Referring now to FIG. 9, additionally or alternatively, in one embodiment, an interposer 902 may be positioned between the IHS 104 and the die 206 as well as the three-dimensional voltage regulator 202. The interposer 802 may provide power from the three-dimensional voltage regulator 202 to the die 206 through interconnects disposed in the interposer 902. The interposer 902 may distribute the voltage(s) received from the interconnect across the back side 218 of the die 206. The interposer 902 may be made of any suitable material, such as silicon.

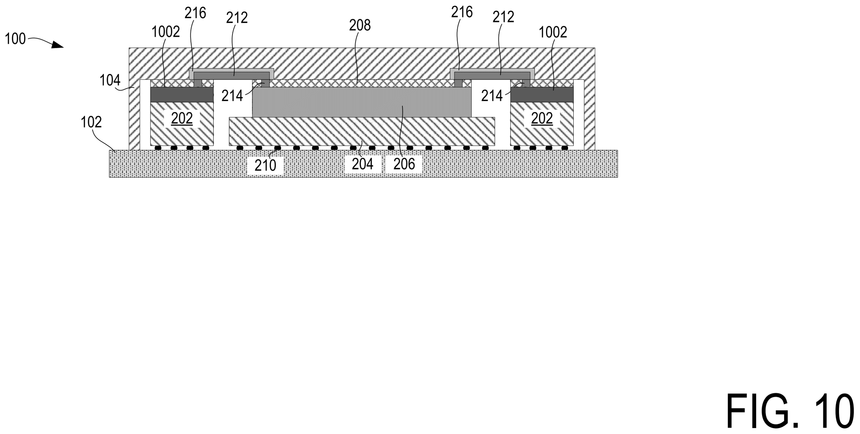

Referring now to FIG. 10, additionally or alternatively, in one embodiment, structural silicon 1002 may be positioned between the IHS 104 and the three-dimensional voltage regulator 202. The structural silicon 1002 may pass voltage from the three-dimensional voltage regulator 202 to the interconnects 212. The structural silicon 1002 may be used when the height of the three-dimensional voltage regulators 202 above the circuit board 102 is less than the height of the die 206 above the circuit board 102. In some embodiments, the structural silicon 1002 may be below the three-dimensional voltage regulators 202, above the circuit board 102. Additionally or alternatively, in some embodiments, structural silicon 1002 may be positioned above the die 206, similar to the interposer 802.

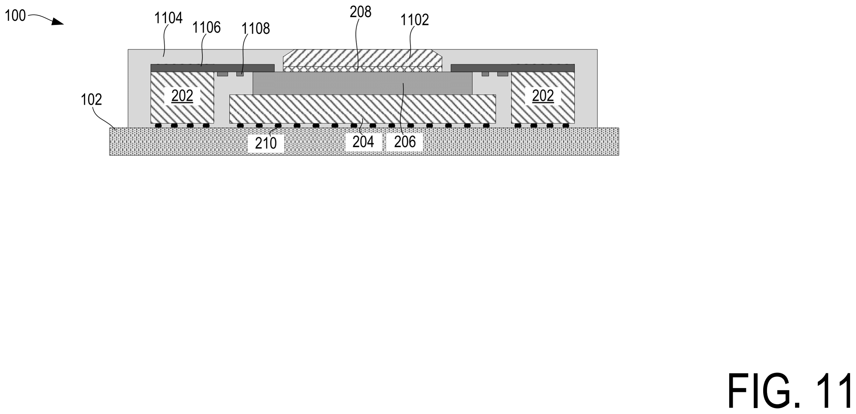

Referring now to FIG. 11, additionally or alternatively, in one embodiment, an overmold 1104 may be applied around various components. In such an embodiment, the integrated heat sink (IHS) 1102 may have the form factor shown in the figure. The IHS 1102 may connect to another, larger IHS above it, to a heat sink, etc. Power bridges 1106 may connect the three-dimensional voltage regulators 202 and the die 206. The power bridges 1106 may be embodied as circuit boards, silicon interposers, conductive strips such as copper, and/or the like. In some embodiments, additional components 1108 such as capacitors and/or inductors may be disposed on a surface of the power bridges 1106. The additional components 1108 may assist with voltage regulation performed by the three-dimensional voltage regulators 202.

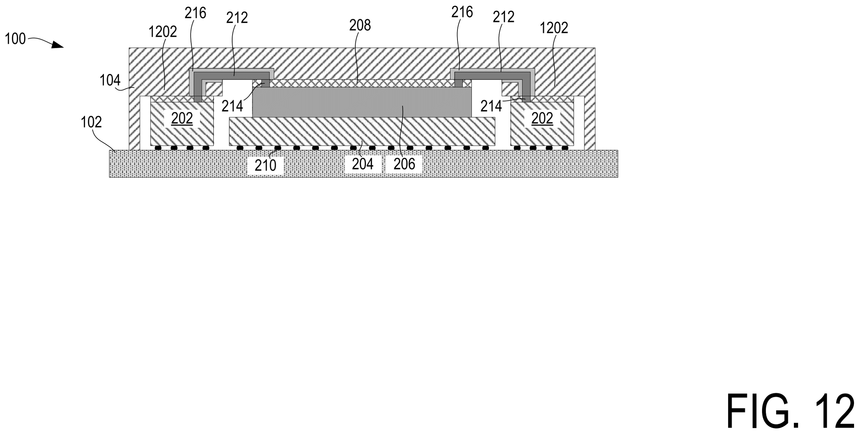

Referring now to FIG. 12, in one embodiment, the IHS 104 may include one or more pedestals 1202 extending towards the three-dimensional voltage regulators 202. Such a pedestal 1202 may be used when, e.g., the height of the three-dimensional voltage regulators 202 is less than that of the substrate 204 and die 206. The pedestal 1202 may allow the IHS 104 to be in strong thermal contact with the die 206 and the three-dimensional voltage regulators 202. In some embodiments, the interconnects 212 may extend through the pedestal 1202, as shown in the figure.

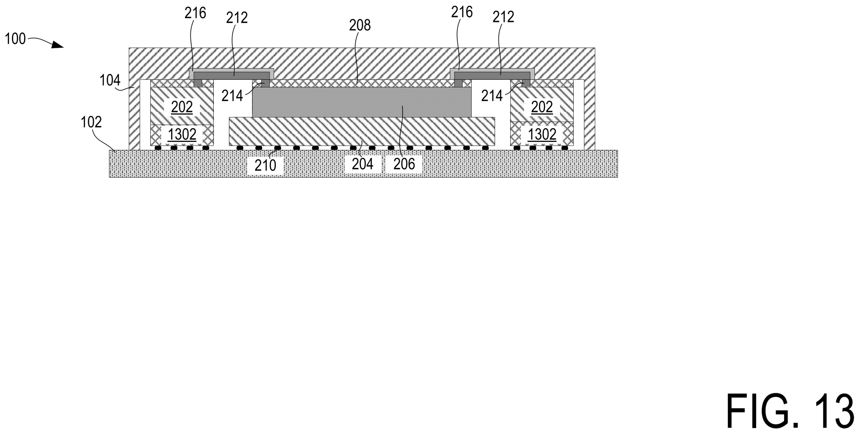

Referring now to FIG. 13, in one embodiment, a spacer circuit board 1302 may be positioned between the three-dimensional voltage regulator 202 and the circuit board 102. Such a spacer circuit board 1302 may be used when, e.g., the height of the three-dimensional voltage regulators 202 is less than that of the substrate 204 and die 206. The spacer circuit board 1302 may allow the IHS 104 to be in strong thermal contact with the die 206 and the three-dimensional voltage regulators 202. In some embodiments, interconnects may extend from the solder balls 210 through the spacer circuit board 1302.

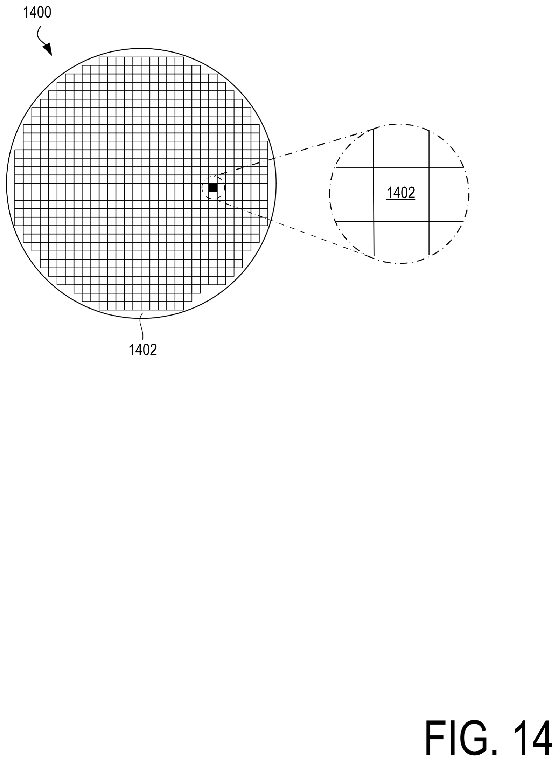

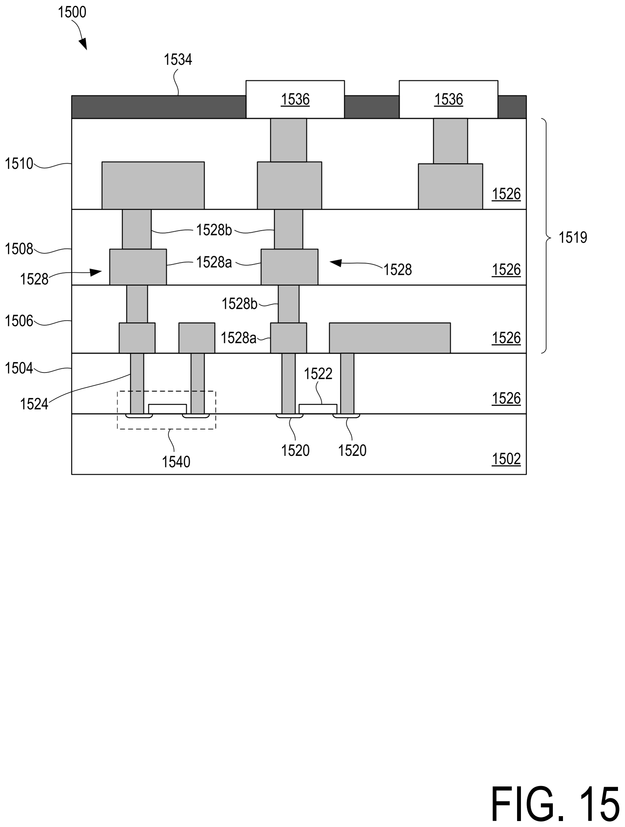

FIG. 14 is a top view of a wafer 1400 and dies 1402 that may be included in any of the integrated circuit components 100 disclosed herein (e.g., as any suitable ones of the dies 206 ). The wafer 1400 may be composed of semiconductor material and dies 1402 having integrated circuit structures formed on a surface of the wafer 1400. The individual dies 1402 may be a repeating unit of an integrated circuit product that includes any suitable integrated circuit. After the fabrication of the semiconductor product is complete, the wafer 1400 may undergo a singulation process in which the dies 1402 are separated from one another to provide discrete "chips" of the integrated circuit product. The dies 1402 may be any of the dies 206 disclosed herein. The dies 1402 may include one or more transistors (e.g., transistors 1540 of FIG. 15, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 1400 or the dies 1402 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array. Various ones of the integrated circuit components 100 disclosed herein may be manufactured using a die-to-wafer assembly technique in which some dies 206 are attached to a wafer 1400 that include others of the dies 206, and the wafer 1400 is subsequently singulated.

FIG. 15 is a cross-sectional view of an integrated circuit structure 1500 that may be included in any of the integrated circuit components 100 disclosed herein (e.g., in any of the dies 206). Multiple instances of the integrated circuit structure 1500 may be included in the dies 1402 (FIG. 14). The integrated circuit structure 1500 may be formed on a die substrate 1502. The die substrate 1502 may be a semiconductor substrate composed of semiconductor material including, for example, n-type or p-type materials (or a combination of both). The die substrate 1502 may include, for example, a crystalline substrate formed using a bulk silicon or a silicon-on-insulator (SOI) substructure. In some embodiments, the die substrate 1502 can comprise a layer of silicon on top of an SOI layer with bulk silicon below the SOI layer. In some embodiments, the die substrate 1502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1502. Although a few examples of materials from which the die substrate 1502 may be formed are described here, any material that may serve as a foundation for an integrated circuit structure 1500 may be used. The die substrate 1502 may be part of a singulated die (e.g., dies 1402 of FIG. 14) or a wafer (e.g., wafer 1400 of FIG. 14).

The integrated circuit structure 1500 may include device layer 1504 disposed on the die substrate 1502. The device layer 1504 may include features of transistors 1540 (e.g., metal oxide semiconductor field-effect transistors (MOSFETs)) formed on the die substrate 1502. The transistors 1540 may include, for example, source and drain regions (S/D regions 1520), a gate 1522 to control current flow between the S/D regions 1520, and S/D contacts 1524 to route electrical signals to and from the S/D regions 1520. The transistors 1540 may include additional features not depicted for the sake of clarity, such as device isolation regions, gate contacts, and the like. The transistors 1540 are not limited to the type and configuration depicted in FIG. 15 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

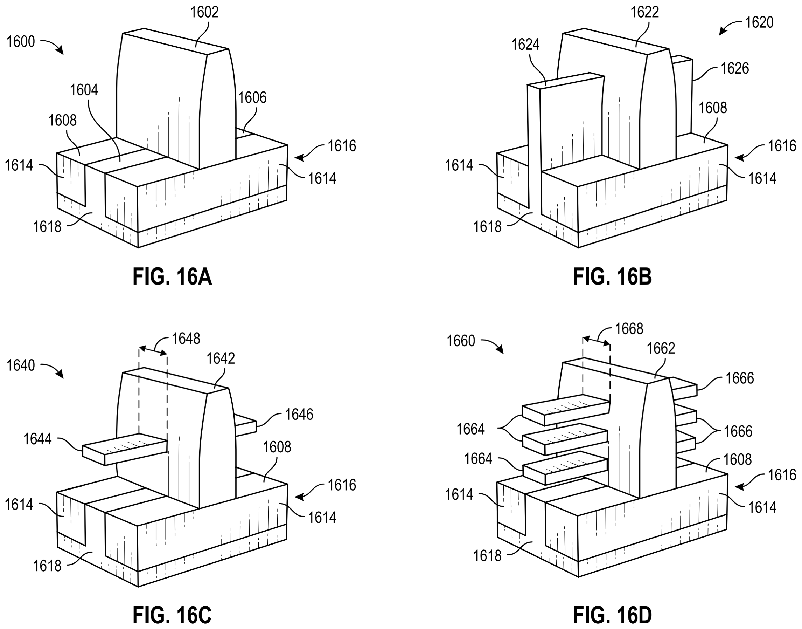

FIGS. 16A-16D are perspective views of example planar, FinFET, gate-all-around, and stacked gate-all-around transistors. The transistors illustrated in FIGS. 16A-16D are formed on a substrate 1616 having a substrate surface 1608 and a bulk region 1618. Isolation regions 1614 separate the source and drain regions of the transistors from other transistors.

FIG. 16A is a perspective view of an example transistor 1600 comprising a gate 1602 that controls current flow between a source region 1604 and a drain region 1606. The transistor 1600 is planar in that the source region 1604, the drain region 1606 and the substrate surface 1608 lie in the same plane.

FIG. 16B is a perspective view of an example transistor 1620 comprising a gate 1622 that controls current flow between a source region 1624 and a drain region 1626. The transistor 1620 is non-planar in that the source region 1624 and the drain region 1626 comprise "fins" that extend upwards from the substrate surface 1608. The transistor 1620 can be referred to as a FinFET. As the gate 1622 encompasses three sides of the fin that extends from the source region 1624 to the drain region 1626, the transistor 1620 can be considered a tri-gate transistor. FIG. 16B illustrates one S/D fin extending through the gate 1622, but multiple S/D fins can extend through the gate of a FinFET transistor.

FIG. 16C is a perspective view of a transistor 1640 comprising a gate 1642 that controls current flow between a source region 1644 and a drain region 1646. The transistor 1640 is non-planar in that the source region 1644 and the drain region 1646 lie in a different plane than the substrate surface 1608. As the gate 1642 encompasses all sides of the channel region of the transistor 1640 that extends from the source region 1644 to the drain region 1646, the transistor 1640 can be referred to as a gate-all-around (GAA) transistor.

FIG. 16D is a perspective view of a transistor 1660 comprising a gate 1662 that controls current flow between multiple elevated source regions 1664 and multiple elevated drain regions 1666. The transistor 1660 is a stacked GAA transistor as the gate controls the flow of current between multiple elevated S/D regions stacked on top of each other. The transistors 1640 and 1660 are considered gate-all-around transistors as the gates encompass all sides of the channel regions of the transistor that extends from the source regions to the drain regions. The transistors 1640 and 1660 can alternatively be referred to as nanowire, nanosheet, or nanoribbon transistors depending on the width (e.g., widths 1648 and 1668 of transistors 1640 and 1660, respectively) of the channel regions extending through the gate.

Returning to FIG. 15, transistors 1540 may include a gate 1522 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 16B, the gate electrode may have an upside-down U-shape that includes a top portion substantially parallel to the surface of the die substrate 1502 and two side portions that are substantially perpendicular to the top surface of the die substrate 1502. In other embodiments, such as the planar FET illustrated in FIG. 16A, at least one of the metal layers that form the gate electrode may be a planar layer that is substantially parallel to the top surface of the die substrate 1502 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 1520 may be formed within the die substrate 1502 adjacent to the gate 1522 of transistors 1540. The S/D regions 1520 may be formed using an implantation/diffusion process or an etching/deposition process, for example. In the former process, dopants such as boron, aluminum, antimony, phosphorous, or arsenic may be ion-implanted into the die substrate 1502 to form the S/D regions 1520. An annealing process that activates the dopants and causes them to diffuse further into the die substrate 1502 may follow the ion implantation process. In the latter process, the die substrate 1502 may first be etched to form recesses at the locations of the S/D regions 1520. An epitaxial deposition process may then be carried out to fill the recesses with material that is used to fabricate the S/D regions 1520. In some implementations, the S/D regions 1520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1520 may be formed using one or more alternate semiconductor materials such as germanium or a group III-V material or alloy. In further embodiments, one or more layers of metal and/or metal alloys may be used to form the S/D regions 1520.

Electrical signals, such as power and/or information-carrying signals (e.g., input/output (I/O) signals, may be routed to and/or from devices (e.g., transistors 1540) of the device layer 1504 through one or more interconnect layers disposed on the device layer 1504 (illustrated in FIG. 15 as interconnect layers 1506-1510). For example, electrically conductive features of the device layer 1504 (e.g., the gate 1522 and the S/D contacts 1524) may be electrically coupled with interconnect structures 1528 of the interconnect layers 1506-1510. The one or more interconnect layers 1506-1510 may form a metallization stack 1519 (which can also be referred to as an "ILD stack" (inter-layer dielectric stack)) of the integrated circuit structure 1500.

The interconnect structures 1528 may be arranged within the interconnect layers 1506-1510 to route electrical signals according to a wide variety of designs; in particular, the arrangement is not limited to the particular configuration of interconnect structures 1528 depicted in FIG. 15. Although a particular number of interconnect layers 1506-1510 is depicted in FIG. 15, embodiments of the present disclosure include integrated circuit structures having more or fewer interconnect layers than depicted.

In some embodiments, the interconnect structures 1528 may include traces or lines 1528a and/or vias 1528b filled with an electrically conductive material such as a metal. The lines 1528a may be arranged to route electrical signals in a direction of a plane that is substantially parallel with a surface of the die substrate 1502 upon which the device layer 1504 is formed. For example, the lines 1528a may route electrical signals in a direction in and out of the page and/or in a direction across the page from the perspective of FIG. 15. The vias 1528b may be arranged to route electrical signals in a direction of a plane that is substantially perpendicular to the surface of the die substrate 1502 upon which the device layer 1504 is formed. In some embodiments, lines 1528a of different interconnect layers 1506-1510 are electrically coupled by vias 1528b.

The interconnect layers 1506-1510 may include a dielectric material 1526 within which the interconnect structures 1528 are disposed, as shown in FIG. 15. In some embodiments, dielectric material 1526 in different ones of the interconnect layers 1506-1510 may have different compositions; in other embodiments, the composition of the dielectric material 1526 between different interconnect layers 1506-1510 may be the same. The device layer 1504 may include a dielectric material 1526 within which the transistors 1540 are disposed and upon which a bottom layer of the metallization stack is located. The dielectric material 1526 that is part of the device layer 1504 may have a different composition than the dielectric material 1526 included in the interconnect layers 1506-1510; in other embodiments, the composition of the dielectric material 1526 in the device layer 1504 may be the same as a dielectric material 1526 included in any one of the interconnect layers 1506-1510.

A first interconnect layer 1506 (which can be referred to as a Metal 1 or "M1" layer) may be formed directly on the device layer 1504. In some embodiments, the first interconnect layer 1506 may include lines 1528a and/or vias 1528b, as shown. The lines 1528a of the first interconnect layer 1506 may be coupled with contacts (e.g., the S/D contacts 1524) of the device layer 1504. The vias 1528b of the first interconnect layer 1506 may be coupled with the lines 1528a of a second interconnect layer 1508.

The second interconnect layer 1508 (which can be referred to as a Metal 2 or "M2" layer) may be formed directly on the first interconnect layer 1506. In some embodiments, the second interconnect layer 1508 may include vias 1528b to couple the lines 1528a of the second interconnect layer 1508 with the lines 1528a of a third interconnect layer 1510. Although the lines 1528a and the vias 1528b are structurally delineated with a line within individual interconnect layers for the sake of clarity, the lines 1528a and the vias 1528b may be structurally and/or materially contiguous (e.g., simultaneously filled during a dual-damascene process) in some embodiments.

The third interconnect layer 1510 (which can be referred to as a Metal 3 or "M3" layer) (and additional interconnect layers, as desired) may be formed in succession on the second interconnect layer 1508 according to similar techniques and configurations described in connection with the second interconnect layer 1508 or the first interconnect layer 1506. In some embodiments, the interconnect layers that are "higher up" in the metallization stack 1519 in the integrated circuit structure 1500 (i.e., farther away from the device layer 1504) may be thicker than the interconnect layers that are lower in the metallization stack 1519, with lines 1528a and vias 1528b in the higher interconnect layers being thicker than those in the lower interconnect layers.

The integrated circuit structure 1500 may include a solder resist material 1534 (e.g., polyimide or similar material) and conductive contacts 1536 formed on the stack of interconnect layers 1506-1510. In FIG. 15, the conductive contacts 1536 are illustrated as taking the form of bond pads. The conductive contacts 1536 may be electrically coupled with interconnect structures 1528 of the top-most layer in the metallization stack 1519 and configured to route electrical signals between the transistors 1540 and components external to the integrated circuit structure 1500. For example, solder bonds may be formed on the conductive contacts 1536 to mechanically and/or electrically couple an integrated circuit component comprising the integrated circuit structure 1500 with another component (e.g., a printed circuit board). The integrated circuit structure 1500 may include additional or alternate structures to route electrical signals from the interconnect layers 1506-1510; for example, the conductive contacts 1536 may include other analogous features (e.g., posts) that can route the electrical signals between the transistors 1540 and external components. The conductive contacts 1536 may serve as the conductive contacts 214, as appropriate.

In some embodiments in which the integrated circuit structure 1500 is part of a double-sided die (e.g., like the die 206) the integrated circuit structure 1500 may include a second metallization stack (not shown) located on the opposite side of the die substrate 1502 from the device layer 1504. This second metallization stack may include multiple interconnect layers as discussed above with reference to the interconnect layers 1506-1510. Through-silicon vias (TSVs) that extend through the die substrate 1502 can provide electrically conductive pathways from the transistors 1540 to the second metallization stack and the second metallizaton stack can electrically couple the TSVs to additional conductive contacts (not shown) located on the opposite side of the integrated circuit structure 1500 from the conductive contacts 1536. These additional conductive contacts may serve as the conductive contacts 214, as appropriate.

In some embodiments, TSVs extending through the die substrate 1502 can be used for routing power and ground signals from conductive contacts located on the opposite side of the integrated circuit structure 1500 from the conductive contacts 1536 to the transistors 1540 and any other components integrated into the integrated circuit structure 1500, and the metallization stack 1519 can be used to route information-carrying signals from the conductive contacts 1536 to transistors 1540 and any other components integrated into the integrated circuit structure 1500. Put another way, the routing of power and ground signals to the transistors 1540 can be separated (via a backside or bottom-side metallizaton stack and TSVs) from the routing of information-carrying signals to the transistors. The power and ground signals are provided by a backside or bottom-side metallization stack and TSVs, and information-carrying signals are provided by a topside metallization stack (e.g., metallization stack 1519).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

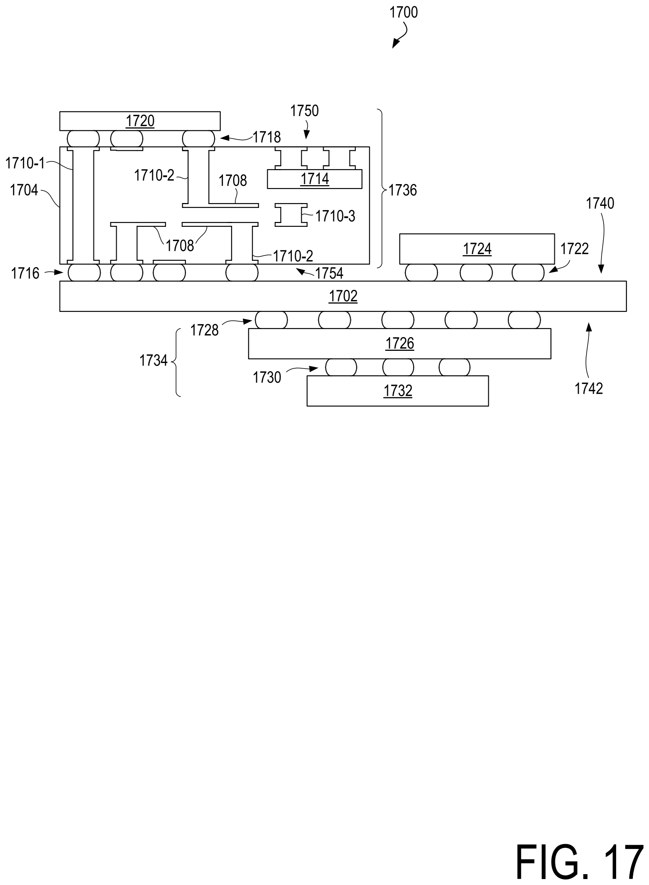

FIG. 17 is a cross-sectional view of an integrated circuit device assembly 1700 that may include any of the integrated circuit components 100 disclosed herein. In some embodiments, the integrated circuit device assembly 1700 may be an integrated circuit components 100The integrated circuit device assembly 1700 includes a number of components disposed on a circuit board 1702 (which may be a motherboard, system board, mainboard, etc.). The integrated circuit device assembly 1700 includes components disposed on a first face 1740 of the circuit board 1702 and a second face 1742 of the circuit board 1702, the second face 1742 opposing the first face 1740. Generally, components may be disposed on either or both of the first face 1740 and the second face 1742 of the circuit board 1702. Any of the integrated circuit components discussed below with reference to the integrated circuit device assembly 1700 may take the form of any suitable ones of the embodiments of the integrated circuit components 100 disclosed herein.

In some embodiments, the circuit board 1702 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 1702. In other embodiments, the circuit board 1702 may be a non-PCB substrate. In some embodiments the circuit board 1702 may be, for example, the circuit board 102.

The integrated circuit device assembly 1700 illustrated in FIG. 17 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 17), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.) The coupling components 1716 may serve as the coupling components illustrated or described for any substrate assembly or substrate assembly components described herein (e.g., integrated circuit components), as appropriate.

The package-on-interposer structure 1736 may include an integrated circuit component 1720 coupled to an interposer 1704. The interposer 1704 may provide an intervening substrate used to bridge the circuit board 1702 and the integrated circuit component 1720. The integrated circuit component 1720 is coupled to the interposer 1704 by coupling components 1718. The coupling components 1718 may take any suitable form, such as the forms discussed above with reference to the coupling components 1716. Although FIG. 17 shows just one integrated circuit component attached to the interposer, multiple integrated circuit components may be coupled to the interposer 1704. Additional interposers may be coupled to the interposer 1704.

The integrated circuit component 1720 may be a packaged or unpacked integrated circuit product that includes one or more integrated circuit dies (e.g., the die 1402 of FIG. 14, a die comprising the integrated circuit structure 1500 of FIG. 15) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 1720, a single monolithic integrated circuit die comprises solder bumps attached to contacts on the die. The solder bumps allow the die to be directly attached to the interposer 1704. The integrated circuit component 1720 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1720 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1720 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1720 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1704 may spread connections to a wider or narrower pitch or reroute a connection to a different connection. For example, the interposer 1704 may couple coupling components 1718 having a first pitch to coupling components 1716 having a wider pitch than the first pitch. In the embodiment illustrated in FIG. 17, the integrated circuit component 1720 and the circuit board 1702 are attached to opposing sides of the interposer 1704. In other embodiments, the integrated circuit component 1720 and the circuit board 1702 may be attached to a same side of the interposer 1704. In some embodiments, three or more components may be interconnected by way of the interposer 1704.

In some embodiments, the interposer 1704 may be formed as a PCB, including multiple metal layers separated from one another by layers of dielectric material and interconnected by electrically conductive vias. In some embodiments, the interposer 1704 may be formed of an epoxy resin, a fiberglass-reinforced epoxy resin, an epoxy resin with inorganic fillers, a ceramic material, or a polymer material such as polyimide. In some embodiments, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias, including but not limited to through hole vias 1710-1 (that extend from a first face 1750 of the interposer 1704 to a second face 1754 of the interposer 1704), blind vias 1710-2 (that extend from the first face 1750 or the second face 1754 of the interposer 1704 to an internal metal layer), and buried vias 1710-3 (that connect internal metal layers).

In some embodiments, the interposer 1704 can comprise a silicon interposer. Through silicon vias (TSV) extending through the silicon interposer can connect connections on a first face of a silicon interposer to an opposing second face of the silicon interposer. In some embodiments, an interposer 1704 comprising a silicon interposer can further comprise one or more routing layers to route connections on a first face of the interposer 1704 to an opposing second face of the interposer 1704.

In some embodiments the interposer 1704, as well as the circuit board 1702, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 1704 or circuit board 1702 to the glass layer. The glass layer can comprise through-glass vias (TGVs) that extend through the glass layer to provide electrically conductive paths through the glass core, glass substrate, or glass layer.

The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The integrated circuit device assembly 1700 may include an integrated circuit component 1724 coupled to the first face 1740 of the circuit board 1702 by coupling components 1722. The coupling components 1722 may take the form of any of the embodiments discussed above with reference to the coupling components 1716, and the integrated circuit component 1724 may take the form of any of the embodiments discussed above with reference to the integrated circuit component 1720.

The integrated circuit device assembly 1700 illustrated in FIG. 17 further includes a package-on-package structure 1734 coupled to the second face 1742 of the circuit board 1702 by coupling components 1728. The package-on-package structure 1734 may include an integrated circuit component 1726 and an integrated circuit component 1732 coupled together by coupling components 1730 such that the integrated circuit component 1726 is disposed between the circuit board 1702 and the integrated circuit component 1732. The coupling components 1728 and 1730 may take the form of any of the embodiments of the coupling components 1716 discussed above, and the integrated circuit components 1726 and 1732 may take the form of any of the embodiments of the integrated circuit component 1720 discussed above. The package-on-package structure 1734 may be configured in accordance with any of the package-on-package structures known in the art.

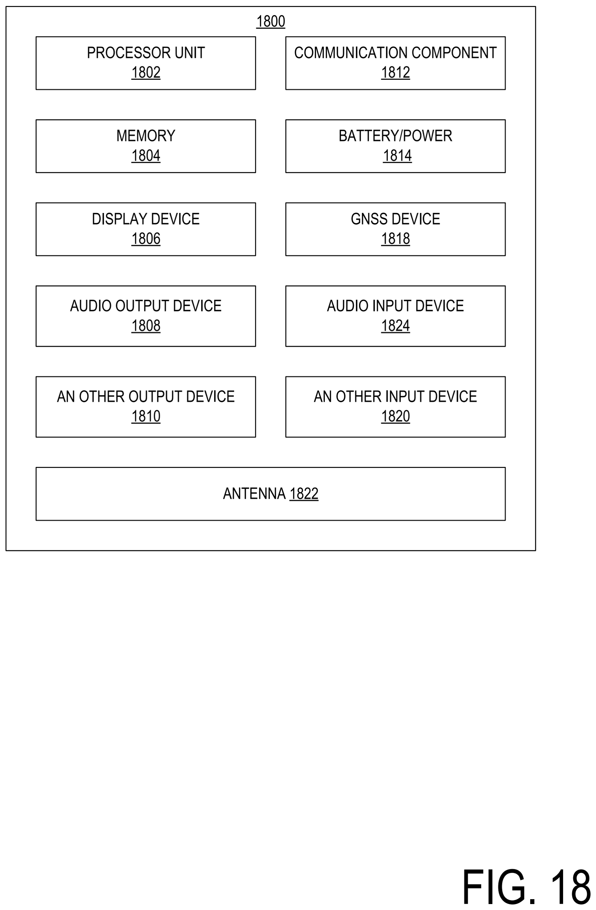

FIG. 18 is a block diagram of an example electrical device 1800 that may include any of the microelectronic assemblies disclosed herein. For example, any suitable ones of the components of the electrical device 1800 may include one or more of the integrated circuit device assembly 1700, integrated circuit component 1720, or integrated circuit structure 1500, integrated circuit dies 1402 disclosed herein, and may be arranged in any of the integrated circuit components 100 disclosed herein. A number of components are illustrated in FIG. 18 as included in the electrical device 1800, but any one or more of these components may be omitted or duplicated, as suitable for the application. In some embodiments, some or all of the components included in the electrical device 1800 may be attached to one or more motherboards mainboards, or system boards. In some embodiments, one or more of these components are fabricated onto a single system-on-a-chip (SoC) die.

Additionally, in various embodiments, the electrical device 1800 may not include one or more of the components illustrated in FIG. 18, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include one or more processor units 1802. As used herein, the terms "processor unit," "processing unit," or "processor" may refer to any device or portion of a device that processes electronic data from registers and/or memory to transform that electronic data into other electronic data that may be stored in registers and/or memory. The one or more processor units 1802 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1800 may include a memory 1804, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1804 may include memory that is located on the same integrated circuit die as the one or more processor units 1802. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 1800, a first one of the one or more processor units 1802 can be heterogeneous or asymmetric to a second one of the one or more processor units 1802 in the electrical device 1800. There can be a variety of differences between the one or more processor units 1802 in a system in terms of a spectrum of metrics of merit including architectural, microarchitectural, thermal, power consumption characteristics, and the like. These differences can effectively manifest themselves as asymmetry and heterogeneity among the one or more processor units 1802 in the electrical device 1800.

In some embodiments, the electrical device 1800 may include a communication component 1812. For example, the communication component 1812 can manage wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication component 1812 may manage wired communications, such as electrical, optical, or any other suitable communication protocols (e.g., IEEE 802.3 Ethernet standards). In some embodiments, the electrical device 1800 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any embedded or wired or wirelessly connected external device that generates an audible indicator, such as speakers, headsets, or earbuds.

The electrical device 1800 may include an audio input device 1824 (or corresponding interface circuitry, as discussed above). The audio input device 1824 may include any embedded or wired or wirelessly connected device that generates a signal representative of a sound, such as microphones, microphone arrays, or digital instruments (e.g., instruments having a musical instrument digital interface (MIDI) output). The electrical device 1800 may include a Global Navigation Satellite System device (GNSS) (or corresponding interface circuitry, as discussed above), such as a Global Positioning System (GPS) device. The GNSS device 1818 may be in communication with a satellite-based system and may determine a geolocation of the electrical device 1800 based on information received from one or more GNSS satellites, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1800 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1800 may be any other electronic device that processes data. In some embodiments, the electrical device 1800 may comprise multiple discrete physical components. Given the range of devices that the electrical device 1800 can be manifested as in various embodiments, in some embodiments, the electrical device 1800 can be referred to as a computing device or a computing system.

### EXAMPLES

Illustrative examples of the technologies disclosed herein are provided below. An embodiment of the technologies may include any one or more, and any combination of, the examples described below.

Example 1 includes an integrated circuit component comprising a circuit board; a three-dimensional voltage regulator, the three-dimensional voltage regulator comprising an inductor, a capacitor, and one or more transistors; a die located on the circuit board, wherein a front side of the die is facing towards the circuit board, wherein a back side of the die is facing away from the circuit board; and an interconnect connected to the three-dimensional voltage regulator and the die, wherein the interconnect is adjacent the back side of the die.

Example 2 includes the subject matter of Example 1, and further including an integrated heat sink, wherein the interconnect is disposed in the integrated heat sink.

Example 3 includes the subject matter of any of Examples 1 and 2, and wherein the integrated heat sink comprises a pedestal extending from a body of the integrated heat sink towards the die.

Example 4 includes the subject matter of any of Examples 1-3, and wherein at least one component of the three-dimensional voltage regulator is mounted on top of another component of the three-dimensional voltage regulator.

Example 5 includes the subject matter of any of Examples 1-4, and wherein a cavity is defined in the circuit board, wherein part of the three-dimensional voltage regulator is disposed in the cavity.

Example 6 includes the subject matter of any of Examples 1-5, and wherein the three-dimensional voltage regulator is mounted on the die.

Example 7 includes the subject matter of any of Examples 1-6, and further including an integrated heat sink, wherein the three-dimensional voltage regulator extends through a gap defined in the integrated heat sink, wherein a cable extends from the three-dimensional voltage regulator to an intermediate bus converter.

Example 8 includes the subject matter of any of Examples 1-7, and further including an interposer adjacent the back side of the die, wherein the interconnect is to supply power from the three-dimensional voltage regulator to the die through the interposer.

Example 9 includes the subject matter of any of Examples 1-8, and further including an interposer adjacent the back side of the die and a top of the three-dimensional voltage regulator, wherein the interposer comprises the interconnect.

Example 10 includes the subject matter of any of Examples 1-9, and further including structural silicon adjacent the three-dimensional voltage regulator.

Example 11 includes the subject matter of any of Examples 1-10, and further including overmold around the three-dimensional voltage regulator and the die.

Example 12 includes the subject matter of any of Examples 1-11, and wherein the three-dimensional voltage regulator is to provide a plurality of voltages.

Example 13 includes the subject matter of any of Examples 1-12, and wherein the three-dimensional voltage regulator is mounted on the circuit board.

Example 14 includes the subject matter of any of Examples 1-13, and further including a substrate, wherein the die is mounted on the substrate, wherein the substrate is mounted on the circuit board.

Example 15 includes an integrated circuit component comprising a circuit board; a voltage regulator located on the circuit board, wherein the voltage regulator comprises a plurality of components, wherein at least one component of the plurality of components of the voltage regulator is disposed between the circuit board and another component of the plurality of components of the voltage regulator; a die located on the circuit board, wherein the die has a front side and a back side, wherein the front side is facing toward the circuit board, wherein the back side is facing away from the circuit board; and an interconnect connected to an output of the voltage regulator and the back side of the die.

Example 16 includes the subject matter of Example 15, and further including an integrated heat sink, wherein the interconnect is disposed in the integrated heat sink.

Example 17 includes the subject matter of any of Examples 15 and 16, and wherein the integrated heat sink comprises a pedestal extending from a body of the integrated heat sink towards the die.

Example 18 includes the subject matter of any of Examples 15-17, and wherein the voltage regulator is mounted on the circuit board.

Example 19 includes the subject matter of any of Examples 15-18, and further including a substrate, wherein the die is mounted on the substrate, wherein the substrate is mounted on the circuit board.

Example 20 includes the subject matter of any of Examples 15-19, and wherein a cavity is defined in the circuit board, wherein part of the voltage regulator is disposed in the cavity.

Example 21 includes the subject matter of any of Examples 15-20, and wherein the voltage regulator is mounted on the die.

Example 22 includes the subject matter of any of Examples 15-21, and further including an integrated heat sink, wherein the voltage regulator extends through a gap defined in the integrated heat sink, wherein a cable extends from the voltage regulator to an intermediate bus converter.

Example 23 includes the subject matter of any of Examples 15-22, and further including an interposer adjacent the back side of the die, wherein the interconnect is to supply power from the voltage regulator to the die through the interposer.

Example 24 includes the subject matter of any of Examples 15-23, and further including an interposer adjacent the back side of the die and a top of the voltage regulator, wherein the interposer comprises the interconnect.

Example 25 includes the subject matter of any of Examples 15-24, and further including structural silicon adjacent the voltage regulator.

Example 26 includes the subject matter of any of Examples 15-25, and further including overmold around the voltage regulator and the die.

Example 27 includes the subject matter of any of Examples 15-26, and wherein the voltage regulator has a width, a length, and a height, wherein a height of the voltage regulator is at least half of the width or at least half of the height or both.

Example 28 includes the subject matter of any of Examples 15-27, and wherein the voltage regulator is to provide a plurality of voltages.

Example 29 includes an integrated circuit component comprising a circuit board; a voltage regulator located on the circuit board; a die located on the circuit board, wherein the die has a front side and a back side, wherein the front side is facing toward the circuit board, wherein the back side is facing away from the circuit board; an integrated heat sink; and an interconnect disposed in the integrated heat sink, the interconnect connecting an output of the voltage regulator to a back side of the die.

Example 30 includes the subject matter of Example 29, and wherein the integrated heat sink comprises a pedestal extending from a body of the integrated heat sink towards the die.

Example 31 includes the subject matter of any of Examples 29 and 30, and wherein the voltage regulator is mounted on the circuit board.

Example 32 includes the subject matter of any of Examples 29-31, and further including a substrate, wherein the die is mounted on the substrate, wherein the substrate is mounted on the circuit board.

Example 33 includes the subject matter of any of Examples 29-32, and wherein at least one component of the voltage regulator is mounted on top of another component of the voltage regulator.

Example 34 includes the subject matter of any of Examples 29-33, and wherein a cavity is defined in the circuit board, wherein part of the voltage regulator is disposed in the cavity.

Example 35 includes the subject matter of any of Examples 29-34, and wherein the voltage regulator is mounted on the die.

Example 36 includes the subject matter of any of Examples 29-35, and further including an integrated heat sink, wherein the voltage regulator extends through a gap defined in the integrated heat sink, wherein a cable extends from the voltage regulator to an intermediate bus converter.

Example 37 includes the subject matter of any of Examples 29-36, and further including an interposer adjacent the back side of the die, wherein the interconnect is to supply power from the voltage regulator to the die through the interposer.

Example 38 includes the subject matter of any of Examples 29-37, and further including an interposer adjacent the back side of the die and a top of the voltage regulator, wherein the interposer comprises the interconnect.

Example 39 includes the subject matter of any of Examples 29-38, and further including structural silicon adjacent the voltage regulator.

Example 40 includes the subject matter of any of Examples 29-39, and further including overmold around the voltage regulator and the die.

Example 41 includes the subject matter of any of Examples 29-40, and wherein the voltage regulator has a width, a length, and a height, wherein a height of the voltage regulator is at least half of the width or at least half of the height or both.

Example 42 includes the subject matter of any of Examples 29-41, and wherein the voltage regulator is to provide a plurality of voltages.

## Claims

1. An integrated circuit component comprising:
a circuit board;
a three-dimensional voltage regulator, the three-dimensional voltage regulator comprising an inductor, a capacitor, and one or more transistors;
a die located on the circuit board, wherein a front side of the die is facing towards the circuit board, wherein a back side of the die is facing away from the circuit board; and
an interconnect connected to the three-dimensional voltage regulator and the die, wherein the interconnect is adjacent the back side of the die.

2. The integrated circuit component of claim 1, further comprising an integrated heat sink, wherein the interconnect is disposed in the integrated heat sink.

3. The integrated circuit component of claim 2, wherein the integrated heat sink comprises a pedestal extending from a body of the integrated heat sink towards the die.

4. The integrated circuit component of any one of claims 1-3, wherein at least one component of the three-dimensional voltage regulator is mounted on top of another component of the three-dimensional voltage regulator.

5. The integrated circuit component of any one of claims 1-4, wherein a cavity is defined in the circuit board, wherein part of the three-dimensional voltage regulator is disposed in the cavity.

6. The integrated circuit component of any one of claims 1-5, wherein the three-dimensional voltage regulator is mounted on the die.

7. The integrated circuit component of claim 6, further comprising an integrated heat sink, wherein the three-dimensional voltage regulator extends through a gap defined in the integrated heat sink, wherein a cable extends from the three-dimensional voltage regulator to an intermediate bus converter.

8. The integrated circuit component of any one of claims 1-7, further comprising an interposer adjacent the back side of the die, wherein the interconnect is to supply power from the three-dimensional voltage regulator to the die through the interposer.

9. The integrated circuit component of any one of claims 1-8, further comprising an interposer adjacent the back side of the die and a top of the three-dimensional voltage regulator, wherein the interposer comprises the interconnect.

10. The integrated circuit component of any one of claims 1-9, further comprising structural silicon adjacent the three-dimensional voltage regulator.

11. The integrated circuit component of any one of claims 1-10, further comprising overmold around the three-dimensional voltage regulator and the die.

12. The integrated circuit component of any one of claims 1-11, wherein the three-dimensional voltage regulator is to provide a plurality of voltages.

13. The integrated circuit component of any one of claims 1-12, wherein the three-dimensional voltage regulator is mounted on the circuit board.

14. The integrated circuit component of any one of claims 1-13, further comprising a substrate, wherein the die is mounted on the substrate, wherein the substrate is mounted on the circuit board.
